# EUROPÄISCHE PATENTSCHRIFT

(11) **EP 1 802 553 B1**
(45) Veröffentlichungstag und Bekanntmachung des Hinweises auf die Patenterteilung: **11.01.2012**
(21) Anmeldenummer: 05813545.0
(22) Anmeldetag: 04.10.2005
(51) Int. Cl.: C01B 21/06, C01B 21/072, C30B 29/40, C30B 17/00, C30B 19/10

(54) **Verfahren zur Erhöhung des Umsatzes von Gruppe-III-Metall zu Gruppe-III-Nitrid in einer Gruppe-III-haltigen Metallschmelze**
Method for increasing the conversion of group III metals to group III nitrides in a fused metal containing group III elements
Procédé pour augmenter la transformation de métal du groupe III en nitrure du groupe III dans un bain fondu contenant un métal du groupe III

(30) Priorität: 05.10.2004 DE 102004048453
(43) Veröffentlichungstag der Anmeldung: 04.07.2007
(73) Patentinhaber: Fraunhofer-Gesellschaft zur Förderung der angewandten Forschung e.V., 80686 München (DE)
(72) Erfinder: FRIEDRICH, Jochen, 90542 Eckental (DE); MÜLLER, Georg, 91094 Landensendlbach (DE); MEISSNER, Elke, 90542 Eckental (DE); BIRKMANN, Bernhard, 63755 Alzenau (DE); HUSSY, Stephan, 90419 Nürnberg (DE)
(74) Vertreter: Gagel, Roland
(86) Internationale Anmeldenummer: PCT/DE2005/001772
(87) Internationale Veröffentlichungsnummer: WO 2006/037311

(56) Entgegenhaltungen:
- WO-A-2004/061923
- DE-A1- 19 929 591
- BAE SEUNG YONG ET AL: "Single-crystalline gallium nitride nanobelts" APPLIED PHYSICS LETTERS, AIP, AMERICAN INSTITUTE OF PHYSICS, MELVILLE, NY, US, Bd. 81, Nr. 1, 1. Juli 2002 (2002-07-01), Seiten 126-128, XP012031754 ISSN: 0003-6951
- MARINACE J C: "SYNTHESIS OF GALLIUM NITRIDE FROM AMMONIUM CHLORIDE AND GALLIUM" IBM TECHNICAL DISCLOSURE BULLETIN, IBM CORP. NEW YORK, US, Bd. 15, Nr. 5, Oktober 1972 (1972-10), Seite 1697, XP001188467 ISSN: 0018-8689
- ELWELL, D. ET AL.: "CRYSTAL GROWTH OF GaN BY THE REACTION BETWEEN GALLIUM AND AMMONIA" JOURNAL OF CRYSTAL GROWTH, Bd. 66, 1984, Seiten 45-54, XP002406305 Amsterdam in der Anmeldung erwähnt

## Beschreibung

### Technisches Anwendungsgebiet

Die vorliegende Erfindung betrifft ein Verfahren zur Erhöhung des Umsatzes von Gruppe-III-Metall zu Gruppe-III-Nitrid in einer Gruppe-III-haltigen Metallschmelze. Das Verfahren wird in erster Linie in der Halbleitertechnik, der Optoelektronik und der Hochfrequenztechnik zur Herstellung von Halbleiterbauelementen eingesetzt.

Das vorliegende Verfahren wird dabei insbesondere zur Herstellung von iso-strukturellen Gruppe-III-Nitrid-Kristallschichten oder -Volumenkristallen (GaN, AlN, InN) oder deren Mischformen auf iso-strukturellen Gruppe-III-Nitrid-Kristallkeimen oder auf Fremdsubstraten durch Abscheidung aus einer Gruppe-III-haltigen Metallschmelze eingesetzt.

### Stand der Technik

Moderne Halbleiterbauelemente für die Optoelektronik, die Kommunikationstechnologie oder die Hochfrequenztechnik, wie z.B. Leuchtdioden oder Laserdioden, basieren häufig auf dem Halbleiter-Materialsystem der Gruppe-III-Nitride (GaN, AlN, InN, oder deren Mischkristalle). Damit die materialspezifischen Vorteile von Nitrid-basierten Halbleiterbauelementen voll ausgeschöpft werden können, müssen die Nitrid-basierten Halbleiterbauelemente auf Substraten abgeschieden werden, die die gleichen Gitterparameter wie die Gruppe III-Nitride selbst aufweisen. Als Substrate eignen sich daher insbesondere iso-strukturelle Gruppe-III-Nitrid-Kristallschichten, die nach bekannten Verfahren der Lösungszüchtung bzw. der Flüssigphasenepitaxie (LPE, Liquid-Phase-Epitaxy) aus einer Gruppe-III-haltigen Metallschmelze in einer stickstoffhaltigen Gasatmosphäre auf einem Substrat oder einem Keim abgeschieden werden.

Ein besonderes, das Kristallwachstum begrenzendes Problem, stellt hierbei der geringe Umsatz von Gruppe-III-Metall zu Gruppe-III-Nitrid in der flüssigen Gruppe-III-Metallschmelze dar. Durch Zugabe von Lösungsmittelzusätzen in die Gruppe-III-Metallschmelze kann der Umsatz von Gruppe-III-Metall zu Gruppe-III-Nitrid beeinflusst werden.

Bekannte Lösungsmittelzusätze, die zur Erhöhung des Umsatzes von Gruppe-III-Metall zu Gruppe-III-Nitrid in der flüssigen Gruppe III-Metallschmelze eingesetzt werden, sind die Elemente Li, Na und K. Bisher wurden insbesondere mit den Lösungsmittelzusätzen Na oder K, GaN-Kristalle mit Dimensionen von 1 bis 6 mm aus einer Ga-haltigen Metallschmelze gezüchtet. Der hohe Dampfdruck des Natriums und des Kaliums stellt jedoch ein erhebliches Hindernis im Hinblick auf die Züchtung größerer iso-struktureller Gruppe-III-Nitrid- Volumenkristalle und damit für eine industrielle Verwertung dieses Verfahrens dar.

Aus dem Artikel von D. Elwell et. al. im Journal of Crystal Growth 66 (1984) 45 - 54 sind des weiteren auch die Lösungsmittelzusätze Bi und Sn bekannt. Allerdings gelingt es hierbei bisher nicht, genügend große und für eine industrielle Produktion qualitativ geeignete iso-strukturelle Gruppe-III-Nitrid-Kristalle oder - Substrate herzustellen.

Die beschriebenen Elemente werden als Lösungsmittelzusätze in Lösungszüchtungsverfahren eingesetzt, die teilweise mit sehr hohen Prozessdrücken und Temperaturen arbeiten. Dies erfordert einen erheblichen gerätetechnischen Aufwand und hat Nachteile für eine kontrollierte Kristallisation von Gruppe-III-Nitriden.

Die bekannten Lösungsmittelzusätze zur Erhöhung des Umsatzes von Gruppe-III-Metall zu Gruppe-III-Nitrid in einer Gruppe-III-haltigen Metallschmelze weisen zusammengefasst den Nachteil auf, dass sie nur zu einer geringen Erhöhung des Umsatzes von Gruppe-III-Metall in Gruppe-III-Nitrid beitragen. Darüber hinaus ist der gerätetechnische Aufwand durch die Verwendung hoher Prozessdrücke und Temperaturen bei einigen hierzu bekannten Verfahren erheblich.

Aus EP 1 754 811 A1 sind als Lösemittelzusätze Fe und Übergangsmetalle bekannt.

In US 5,637,531 wird die Züchtung von Gruppe-III-Nitriden aus einer Gruppe-III-Metallschmelze beschrieben, wobei die Wachstumsrate über den Prozessdruck eingestellt wird. Die Gruppe-III-Nitride können durch Zugabe von Dotierstoffen dotiert werden.

Neben den beschriebenen Verfahren der Kristallzüchtung aus der Metallschmelze ist durch WO 2004/061923 A ein Verfahren zur Züchtung von Gallium-Nitrid-Einkristallen bekannt, bei dem vorzugsweise GaN in nichteinkristalliner Form in einem superkritischen Fluid, wie Ammoniak oder Hydrazin, gelöst wird und auf einem Kristallisationskeim abgeschieden wird.

Die Aufgabe der vorliegenden Erfindung besteht darin, ein Verfahren anzugeben, mit dem der Umsatz von Gruppe-III-Metall zu Gruppe-III-Nitrid in einer Gruppe-III-haltigen Metallschmelze bei Prozessdrücken < 1 x 10⁸ Pa und Temperaturen < 1100°C erhöht wird.

### Darstellung der Erfindung

Die Aufgabe wird mit dem Verfahren gemäß dem Patentanspruch 1 gelöst, der ein Verfahren zur Erhöhung des Umsatzes von Gruppe-III-Metall zu Gruppe-III-Nitrid in einer Gruppe-III-haltigen Metallschmelze beschreibt. Vorteilhafte Ausgestaltungen des Verfahrens sind Gegenstand der Unteransprüche sowie der Beschreibung, insbesondere dem Ausführungsbeispiel zu entnehmen.

Das erfindungsgemäße Verfahren zur Erhöhung des Umsatzes von Gruppe-III-Metall zu Gruppe-III-Nitrid in einer Gruppe-III-haltigen Metallschmelze, unter Stickstoffeintrag in die Gruppe-III-haltige Metallschmelze, bei Temperaturen ≤ 1100°C und bei Drücken ≤ 1 x 10⁸ Pa, zeichnet sich dadurch aus, dass der Gruppe-III-haltigen Metallschmelze als Lösungsmittelzusatz zumindest ein Element der folgenden Elemente C und Ge oder eine Legierung oder eine Verbindung dieser Elemente, insbesondere ihrer Nitride zugegeben wird.

Der Stickstoffeintrag erfolgt durch einen stickstoffhaltigen gasförmigen Stoff, beispielsweise Ammoniak (NH₃) oder Hydrazin (H₂N-NH₂), und/ oder durch einen stickstoffhaltigen Feststoff, beispielsweise GaN, in stickstoffhaltiger (N₂) Atmosphäre.

Die Konzentration des Lösungsmittelzusatzes in der Gruppe-III-Metallschmelze, die Prozesstemperatur, der Prozessdruck sowie der Stickstoffeintrag werden dabei, in Abhängigkeit des jeweiligen Lösungsmittelzusatzes, gewählt. Dies stellt für den Fachmann keine Probleme dar.

Die Zugabe eines erfindungsgemäßen Lösungsmittelzusatzes, führt neben der Erhöhung des Umsatzes von Gruppe-III-Metall zu Gruppe-III-Nitrid in der flüssigen Gruppe-III-Metallschmelze, auch zu weiteren Wirkungen im Lösungszüchtungsprozess. So wird beispielsweise abhängig von der Wahl des Lösungsmittelzusatzes die Wachstumskinetik, die Keimbildung oder die Oberflächenspannung der Gruppe-III-haltigen Metallschmelze derart beeinflusst, dass die Bildung von großen iso-strukturellen Gruppe-III-Nitrid-Volumenkristallen oder - Kristallschichten möglich ist.

### Kurze Beschreibung der Zeichnungen

Die Erfindung wird nachstehend ohne Beschränkung des allgemeinen Erfindungsgedankens anhand eines Ausführungsbeispiels, bei dem Germanium (Ge) als Lösungsmittelzusatz eingesetzt wird, und unter Bezugnahme auf die Zeichnungen exemplarisch beschrieben:
- Fig.1: schematisierte Querschnittsdarstellung des Modellreaktors, und
- Fig. 2: Darstellung des Umsatzes von Ga zu GaN in Prozent als Funktion des Ge-Gehaltes der Ga-Metallschmelze.

### Wege zur Ausführung der Erfindung

In mehreren Versuchen wird eine erfindungsgemäße Zusammensetzung der Gruppe-III-Metallschmelze bestehend aus dem Gruppe-III-Metall Gallium(Ga)und dem Gruppe-IV-Halbmetall Germanium(Ge)als Lösungsmittelzusatz verwendet, und zunächst als homogene Metallschmelze erschmolzen.

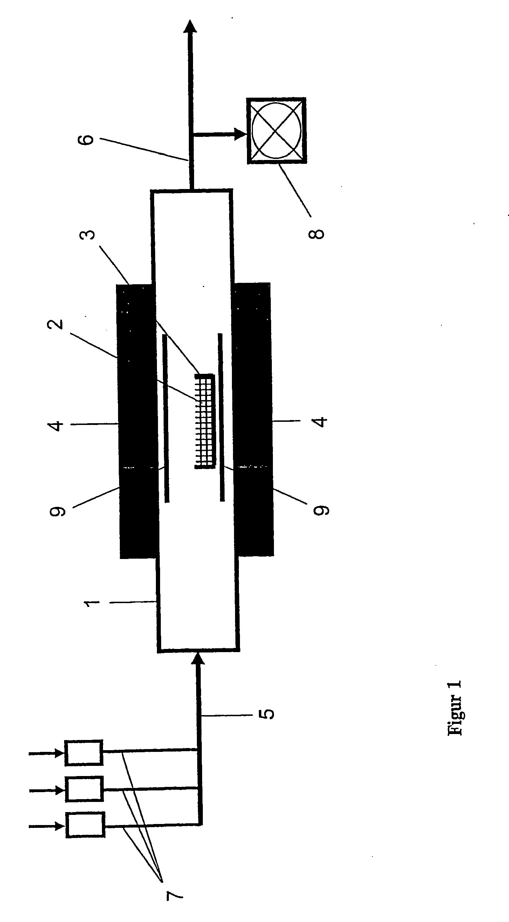

Die Versuche werden in einem Modellreaktor durchgeführt, der in Figur 1 schematisch dargestellt ist. Er besteht aus einer verschließbaren Quarzglasampulle 1, die in Richtung ihrer Längsachse außen von einem Rohrofen 4 umschlossen wird. Eine Probe der erfindungsgemäßen Metallschmelze 2 befindet sich in einem Boot 3 aus Bornitrid oder aus Quarzglas innerhalb der Quarzglasampulle 1. Das Boot ist auf einem Quarzglasliner 9 innerhalb der Quarzglasampulle 1 angeordnet. Die Quarzglasampulle 1 weist eine Gaszuführung 5 für das Einströmen des Trägergases und eines stickstoffhaltigen reaktiven, gasförmigen Stoffes, sowie eine Abluftabführung 6 auf. Der Zufluss der einströmenden Gase wird über Massenflussregler 7 gesteuert. Das Trägergas besteht während aller Versuche aus Stickstoff (N₂). Als reaktiver stickstoffhaltiger Stoff wird Ammoniak (NH₃) verwendet. Während aller Versuche wird das Mischungsverhältnis N₂/NH₃ von 4:1 konstant gehalten. Die Abluftführung 6 ist mit einer Turbomolekularpumpe 8 verbunden, mit der die Quarzglasampulle evakuiert werden kann.

Um den Umsatz von Ga zu GaN in der Probe 2 zu ermitteln, wird die eingesetzte Probe 2 jeweils vor und nach dem Versuch gewogen. Die Gewichtsänderung der Probe 2 dient als Bestimmungsparameter für den Umsatz von Ga zu GaN, unter der Annahme, dass die gesamte Gewichtszunahme aus der Umwandlung von Ga zu GaN resultiert. Das Vorliegen dieser Annahme wird jeweils anhand von röntgenographischer Phasenanalyse überprüft. Als Zeitdauer für den jeweiligen Versuch werden zwei bis drei Stunden gewählt. Die Durchflussrate der Gase wird so gewählt, dass es in der Quarzglasampulle 1 innerhalb einer halben Stunde zum vollständigen Austausch der Gasatmosphäre kommt.

Es werden mehrere Versuche durchgeführt, wobei die Reaktionstemperatur von 930°C bis 970°C sowie das Verhältnis von Ge zu Ga in der Ga-haltigen Metallschmelze bei sonst gleichen Bedingungen variiert wird.

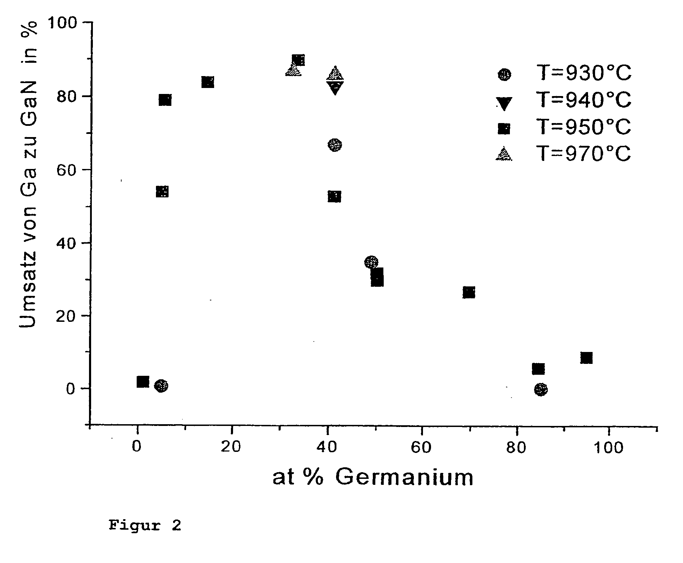

In Figur 2 ist die Auswertung der Versuchsergebnisse graphisch dargestellt. Sie zeigt den Umsatz von Ga zu GaN in Prozent als Funktion des Ge-Gehaltes der Ga-haltigen Metallschmelze bei verschiedenen Reaktionstemperaturen T. Deutlich zu erkennen ist, dass bei zunehmendem Ge-Gehalt in der Metallschmelze bis auf 10%, der Umsatz von Ga zu GaN zunächst um ca. 80 % stark ansteigt, bei Ge-Gehalten von zwischen 10% - 40% der Umsatz von Ga zu GaN nur noch gering auf 90 % anwächst, um dann bei noch höheren Ge-Gehalten wieder stark zu sinken.

Damit ist gezeigt, dass Ge als erfindungsgemäßer Lösungsmittelzusatz in einer Ga-Metallschmelze bei entsprechenden Prozessbedingungen eine erhebliche Erhöhung des Umsatzes von Ga zu GaN in einer Ga haltigen Metallschmelze bei Temperaturen ≤ 1100°C und bei Drücken unter 1 x 10⁸ Pa, insbesondere bei Umgebungsdruck bewirkt.

Wird Ge als Lösungsmittelzusatz einer Gruppe-III-Metallschmelze beigegeben, so können, bei entsprechenden Lösungszüchtungs-Prozessbedingungen, große iso-strukturelle Gruppe-III-Nitrid-volumenkristalle oder -Kristallschichten mit einem Durchmesser > 10 mm oder Kristallschichten mit Dicken > 10 µm, und Versetzungsdichten ≤ 10⁸ cm⁻² hergestellt werden.

### Bezugszeichenliste

- 1: Quarzglasampulle
- 2: Probe einer Gruppe-III-Metallschmelze mit Lösungsmittelzusatz
- 3: Boot
- 4: Rohrofen
- 5: Gaszuleitung
- 6: Abluftableitung
- 7: Massenflussregler
- 8: Turbomolekularpumpe
- 9: Quarzglasliner

## Patentansprüche

1. Verfahren zur Erhöhung des Umsatzes von Gruppe-III-Metall zu Gruppe-III-Nitrid in einer Gruppe-III-haltigen Metallschmelze im Rahmen einer Herstellung von iso-strukturellen Gruppe-III-Nitrid-Kristallschichten oder -Volumenkristallen auf isostrukturellen Gruppe-III-Nitrid-Kristallkeimen oder Fremdsubstraten, unter Stickstoffeintrag in die Gruppe-III-haltige Metallschmelze, bei Temperaturen ≤ 1100°C und bei Drücken unter 1 x 10⁸ Pa, wobei der Gruppe-III-haltigen Metallschmelze ein Lösungsmittelzusatz, der zumindest ein Element der folgenden Elemente C und Ge oder eine Legierung oder eine Verbindung dieser Elemente, insbesondere ihrer Nitride enthält, zugegeben wird.

2. Verfahren nach Anspruch 1,
**dadurch gekennzeichnet, dass** der Stickstoffeintrag in die Metallschmelze durch ein Gasgemisch erfolgt, das aus einem Trägergas und einem reaktiven stickstoffhaltigen Stoff besteht, wobei als Trägergas ein Gemisch aus Stickstoff (N₂) und Wasserstoff (H₂), und als reaktiver stickstoffhaltiger Stoff Ammoniak (NH₃) oder Hydrazin (H₂N-NH₂) verwendet wird.

3. Verfahren nach Anspruch 1,
**dadurch gekennzeichnet, dass** der Stickstoffeintrag in die Metallschmelze durch einen stickstoffhaltigen Feststoff in Stickstoffatmosphäre (N₂)erfolgt.

4. Verfahren nach Anspruch 3,
**dadurch gekennzeichnet, dass** GaN als stickstoffhaltiger Feststoff verwendet wird.

5. Verfahren nach einem der Ansprüche 1 bis 4,
**dadurch gekennzeichnet, dass** das Verfahren zur Herstellung von Kristallschichten oder Volumenkristallen aus iso-strukturellem Gruppe III-Nitrid oder aus Mischungen verschiedener Gruppe III-Nitride durch Abscheidung aus einer Gruppe III haltigen Metallschmelze eingesetzt wird.

6. Verfahren nach einem der Ansprüche 1 bis 5,
**dadurch gekennzeichnet, dass** als Lösungsmittelzusatz das Element Ge oder eine Legierung oder eine Verbindung dieses Elementes, insbesondere seiner Nitride, zugegeben wird, durch den die Gallium-haltige Metallschmelze einen Ge-Gehalt von 10 - 40 at% Ge erhält.

## Claims

1. A method for increasing the conversion of group-III-metal to group-III-nitride in a metal melt which contains group III metal as part of the production of isostructural group-III-nitride crystal layers or volume crystals on isostructural group-III-nitride crystal seeds or foreign substrates with input of nitrogen into the metal melt containing group III metal at temperatures ≤ 1100°C and at pressures less than 1 x 10⁸ Pa, wherein a solvent additive containing at least one element of the following elements C and Ge or one alloy or one compound of these elements, in particular their nitrides, is added to the metal melt that contains the group III metal.

2. The method according to Claim 1,
**characterized in that**
the nitrogen input into the metal melt is accomplished by a gas mixture consisting of a carrier gas and a reactive substance containing nitrogen, wherein a mixture of nitrogen (N₂) and hydrogen (H₂) is used as the carrier gas, and ammonia (NH₃) or hydrazine (H₂N-NH₂) is used as the reactive nitrogenous substance.

3. The method according to Claim 1,
**characterized in that**
the nitrogen input into the metal melt is accomplished through a solid that contains nitrogen in an atmosphere of nitrogen (N₂).

4. The method according to Claim 3,
**characterized in that**
GaN is used as the solid that contains nitrogen.

5. The method according to any one of Claims 1 to 4,
**characterized in that**
the method is used to produce crystal layers or volume crystals of isostructural group-III-nitride or mixtures of different group-III-nitrides by deposition from a metal melt containing group III metal.

6. The method according to any one of Claims 1 to 5,
**characterized in that**
the element Ge or an alloy or a compound of this element, in particular its nitrides, is added as the solvent additive, so that the metal melt which contains gallium has a Ge content of 10 - 40 at% Ge.

## Revendications

1. Procédé destiné à augmenter, dans le cadre de la préparation de couches cristallines ou de cristaux de volume d'un nitrure de groupe III isostructurel sur des germes cristallins d'un nitrure de groupe III isostructurel ou des substrats étrangers, le rendement de la transformation d'un métal de groupe III en nitrure de groupe III au sein d'un métal en fusion contenant du groupe III, en introduisant de l'azote dans ledit métal en fusion contenant du groupe III, à des températures ≤ 1100°C et des pressions inférieures à 1 x 10⁸ Pa, dans lequel un solvant auxiliaire contenant au moins un des éléments suivants C et Ge ou un alliage ou un composé de ses éléments, notamment de leurs nitrures, est ajouté audit métal en fusion contenant du groupe III.

2. Procédé selon la revendication 1,
**caractérisé en ce que** l'introduction d'azote dans le métal en fusion à réalisée au moyen d'un mélange de gaz constitué d'un gaz vecteur et d'une matière réactive azotée, le gaz vecteur mis en oeuvre étant un mélange d'azote (N₂) et d'hydrogène (H₂) et la matière réactive azotée mise en oeuvre étant de l'ammoniac (NH₃) ou de l'hydrazine (H₂N-NH₂)

3. Procédé selon la revendication 1,
**caractérisé en ce que** l'introduction d'azote dans le métal en fusion est réalisée au moyen au solide azoté sous atmosphère d'azote (N₂).

4. Procédé selon la revendication 3,
**caractérisé en ce que** le solide azoté mis en oeuvre est le GaN.

5. Procédé selon l'une des revendications 1 à 4,
**caractérisé en ce que** ledit procédé est mis en oeuvre pour préparer, par précipitation à partir d'un métal en fusion contenant du groupe III, des couches cristallines ou des cristaux de volume constitués d'un nitrure de groupe III isostructurel ou de mélanges de différents nitrures de groupe III.

6. Procédé selon l'une des revendications 1 à 5,
**caractérisé en ce que** l'on ajoute, en tant que solvant auxiliaire, l'élément Ge ou un alliage ou un composé de cet élément, notamment de ses nitrures, pour ainsi porter à 10 à 40 at.-% la teneur en Ge du métal en fusion contenant du gallium.
